# EUROPEAN PATENT APPLICATION

(11) **EP 3 660 888 A1**
(43) Date of publication of application: **03.06.2020**
(21) Application number: 18209142.1
(22) Date of filing: 29.11.2018
(51) Int. Cl.: H01L 21/67, H01L 21/677

(54) **CONVEYOR ARRANGEMENT AND METHOD FOR CONVEYING ELECTRONIC DEVICE**

(71) Applicant: JOT Automation Oy, 90590 Oulu (FI)
(72) Inventor: Puttonen, Mika, 90590 Oulu (FI)
(74) Representative: Kolster Oy Ab

(57) **Abstract**

A conveyor arrangement (100) for conveying an electronic device (102) comprising side rails (104A, 104B) configured to form a conveyor lane (106) for transferring the electronic device (102), a transfer member (108) configured to transfer the electronic device (102) along the conveyor lane (106), a pusher (110) configured to push the electronic device (102) off from the conveyor lane (106) and an actuator (112) configured to set the pusher (110) from a non-functional state (S1) to a functional state (S2). In the functional state (S2) a movement of the transfer member (108) is configured to move the pusher (110) to push the electronic device (102) off from the conveyor lane (106).

## Description

### Field

The invention relates to a conveyor arrangement and method for conveying an electronic device in a manufacturing process.

### Background

Electronic devices, such as mobile phones, tablet computers, laptops and the like, are transferred in their manufacturing process via conveyors. The conveyors are used to transfer the electronic devices between different phases of the manufacturing process. For example, a testing of the electronic device may be a one phase of the manufacturing process. The electronic devices are tested in the testing system which may comprise one or more testing units, wherein the test(s) are carried out. The conveyors are used, for example, for moving the electronic devices to/from the testing unit. If the electronic device fails the test, the failed electronic device is taken aside from the testing system and directed to a failure analysis and/or a repair process. The failed electronic devices are placed, for example, into a separate compartment, wherein they are waiting for the analysis and/or repair activities. The failed electronic device is transferred by the conveyor from the testing unit into the compartment. To move the electronic device off from the conveyor into the compartment may be challenging if the conveyor or the compartment, where the electronic device is going to be placed, is not provided with an apparatus which assists the movement of the electronic device from the conveyor to the compartment. Currently there are many solutions available to move the electronic device off from the conveyor but the solutions are often complex and require constant adjustment and maintenance.

Hence, there is a need for improved solution to move the electronic device off from the conveyor.

### Brief description

The invention is defined by the independent claims. Embodiments are defined in the dependent claims.

### List of drawings

Example embodiments of the present invention are described below, by way of example only, with reference to the accompanying drawings, in which
Figures 1, 2A, 2B, 2C, 3 and 4 illustrate the conveyor arrangement according to some embodiments; and
Figure 5 illustrates a method according to an embodiment.

### Description of embodiments

The following embodiments are only examples. Although the specification may refer to "an" embodiment in several locations, this does not necessarily mean that each such reference is to the same embodiment(s), or that the feature only applies to a single embodiment. Single features of different embodiments may also be combined to provide other embodiments. Furthermore, words "comprising" and "including" should be understood as not limiting the described embodiments to consist of only those features that have been mentioned and such embodiments may contain also features/structures that have not been specifically mentioned. All combinations of the embodiments are considered possible if their combination does not lead to structural or logical contradiction.

In order to ensure a high quality and to reduce failures of manufactured electronic devices, e.g. mobile phones, tablets, portable computers and/or their elements or electric circuits, various tests are carried out in the testing system which may be a part of the manufacturing process of the electronic device. The testing system may comprise, for example, one or more testing units wherein the testing of the electronic device is carried out and one or more conveyors for moving the electronic devices in the testing system. If the electronic device fails in the testing it is taken aside from the testing system and placed, for example, into the separate compartment for further analysis and possible repairing operations. The failed electronic device is usually transferred into the compartment by the conveyor wherein some kind of apparatus is often used for moving the electronic device from conveyor into the compartment. The apparatus may be placed, for example, to the conveyor or the compartment. The conveyor arrangement according to the invention provides a sophisticated solution for moving the electronic device off from the conveyor, for example, into the separate compartment or any other location which is near enough the conveyor arrangement.

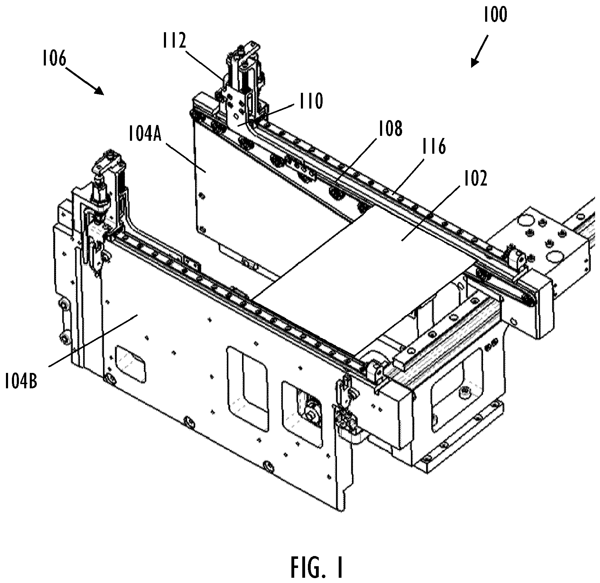

Figure 1 illustrates an embodiment of a conveyor arrangement 100. The conveyor arrangement 100 for conveying an electronic device 102 comprises side rails 104A, 104B configured to form a conveyor lane 106 for transferring the electronic device 102, a transfer member 108 configured to transfer the electronic device 102 along the conveyor lane 106, a pusher 110 configured to push the electronic device 102 off from the conveyor lane 106 and an actuator 112 configured to set the pusher 110 from a non-functional state S1 to a functional state S2. In the functional state S2 the pusher 110 and the transfer member 108 are configured to be in contact with each other such that a movement of the transfer member 108 is configured to move the pusher 110 to push the electronic device 102 off from the conveyor lane 106.

The side rails 104A, 104B are side parts of the conveyor structure which may be mounted, for example, to a frame of the conveyor. In some cases, the side rails 104A, 104B may also form the frame of the conveyor. There also may be other parts and components which are mounted to the side rails 104A, 104B. The side rails 104A, 104B form the conveyor lane 106 in the conveyor arrangement 100 which is used to transfer the electronic device 102. In other words, the side rails 104A, 104B define a width and a length of the conveyor lane 106. The electronic device 102 is placed substantially between the side rails 104A, 104B and hence, a distance between the side rails 104A, 104B is adjusted according to a width of the electronic device 102 which is going to be transferred in the conveyor. The side rails 104A, 104B may be movable which enables the adjustment of the distance between the side rails 104A, 104B.

The side rails 104A, 104B may also define the length of the conveyor lane 106. The length of the conveyor lane 106 is a transfer distance of the conveyor arrangement 100, in other words, how far the electronic device 102 can be transferred with the conveyor. In an embodiment the length of the conveyor lane 106 may also be adjustable. The conveyor arrangement 100 may also be adjusted in a height direction. For example, the conveyor lane 106 may receive the electronic device 102 from a one height and move it off from the conveyor lane 106 in another height which is different than the first height. The height of the conveyor arrangement 100 may be adjusted during the transfer movement of the electronic device 102 on the conveyor lane 106 without stopping the movement.

The transfer member 108 is an element which, in contact with the electronic device 102, moves the electronic device 102 on the conveyor lane 106. The transfer member 108 may be mounted to the side rails 104A, 104B in the conveyor arrangement 100, for example, so that the transfer member 108 is substantially between the side rails 104A, 104B. The transfer member 108 may also be connected with a plurality of other components like, for example, a motor and transmission components. The motor provides a driving force which is transferred via the transmission components to the transfer member 108. The driving force moves the transfer member 108 and movement of the transfer member 108 moves also the electronic device 102 on the conveyor lane 106, when the transfer member 108 is in contact with the electronic device 102. The direction of the transfer movement of the transfer member 108 may be adjusted so that the electronic device 102 can be transferred two opposite directions on the conveyor lane 106.

The pusher 110 is used for moving the electronic device 102 off from the conveyor lane 106. The pusher 110 enhances the function of the transfer member 108 when the electronic device 102 is going to be moved off from the conveyor lane 106. The pusher 110 helps especially in the case wherein the contact between the electronic device 102 and the transfer member 108 is partial at the end of the transfer movement. For example, the electronic device 102 may contact the transfer member 108 only partly at the end of the transfer movement because a part of the electronic device 102 is already off from the conveyor lane 106. The partial contact between the electronic device 102 and the transfer member 108 is not necessarily sufficient to move the electronic device 102 totally off from the conveyor lane 106 because of a lack of a friction. Therefore, there is a risk that the electronic device 102 is not properly moved off from the conveyor lane 106 into the other place. In other words, the transfer member 108 alone may not be able to move the electronic device 102 totally off from the conveyor lane 106 properly. Because of this, the pusher 110 is used to push the electronic device 102 off from the conveyor lane 106.

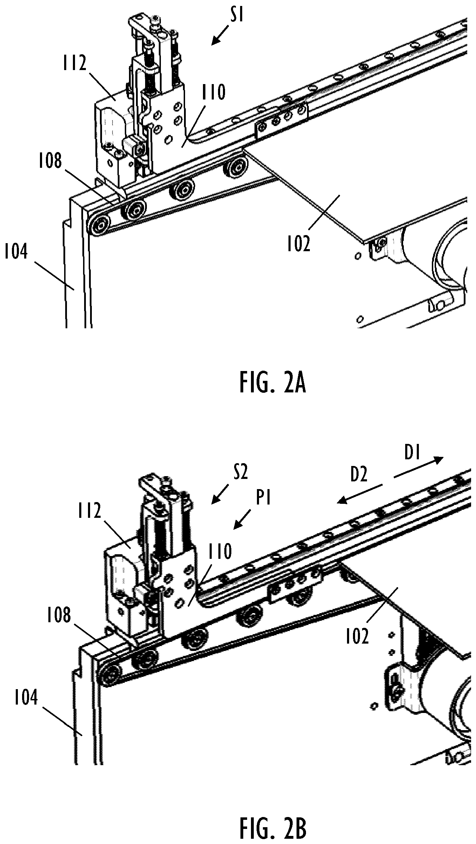

Figure 2A and 2B illustrate a function of the actuator 112. The actuator 112 is used to set the pusher 110 from the non-functional state S1 to the functional state S2. Figure 2A illustrates a situation wherein the pusher 110 is in the non-functional state S1 and Figure 2B illustrates a situation wherein the pusher 110 is in the functional state S2. The pusher is lifted up by the actuator 112 when the pusher 110 is in the non-functional state S1 and the actuator 112 also blocks the movement of the pusher 110 in the transferring direction. The actuator 112 may comprise, for example, a cylinder which can move the pusher 110 from one state to other, in other words, can lay down the pusher 110 to the functional state S2. Instead of the cylinder or in addition to the cylinder, the actuator 112 may comprise also other components which can perform the same movement. In an embodiment, the actuator 112 is a separate apparatus in the conveyor arrangement 100 and the actuator 112 may be mounted, for example, to the side rail 104A, 104B or the frame of the conveyor. In some other embodiment, the actuator 112 may be a part of the pusher 110.

The pusher 110 is positioned in the non-functional state S1 so that it does not affect the function of the conveyor arrangement 100. In the functional state the pusher 110 is positioned so that the pusher 110 and the transfer member 108 are in contact with each other and because of the contact, the pusher 110 moves with the transfer member 108 when the transfer member 108 is moved. In other words, the movement of the transfer member 108 moves also the pusher 110. The structure of the pusher 110 may comprise, for example, one or more springs or other equivalent component which press the pusher 110 against the transfer member 108 to ensure the proper contact between the pusher 110 and the transfer member 108 to move the pusher 110.

For example, the pusher 110 in the non-functional state S1 is lifted up by the actuator 112 so that the pusher 110 is not in contact with the transfer member 108 and does not move in the transfer direction and hence, does not affect the function of the conveyor arrangement 100 at all. When the pusher 110 is needed for pushing the electronic device 102 off from the conveyor, the pusher 110 is moved down to the functional state S2 by the actuator 112 wherein the pusher 110 and the transfer member 108 are in contact with each other so that the movement of the transfer member 108 moves also the pusher 110 in the conveyor lane 106. Hence, the movement of the transfer member 108 moves the electronic device 102 and also the pusher 110 in the conveyor lane 106. When the contact between the transfer member 108 and electronic device 102 is only partial at the end of the conveyor lane 106 and the transfer member 108 is not able move the electronic device 102 properly, the movement of the pusher 110 pushes the electronic device 102 off from the conveyor lane 106. The pusher 110 and the transfer member 108 are configured to stay in contact all the time when the pusher 110 is in the functional state S2.

The described conveyor arrangement 100 provides an efficient solution to move the electronic device 102 easily off from the conveyor lane 106. The pusher 110 utilize the power of the transfer member 108 and hence, an own power source for the pusher 110 is not necessarily needed in the conveyor arrangement 100. This makes the structure of the pusher 110 very compact and simple. Because of the compact and simple structure, the pusher 110 does not need a lot of space in the conveyor arrangement 100 or not need a lot of maintenance activities.

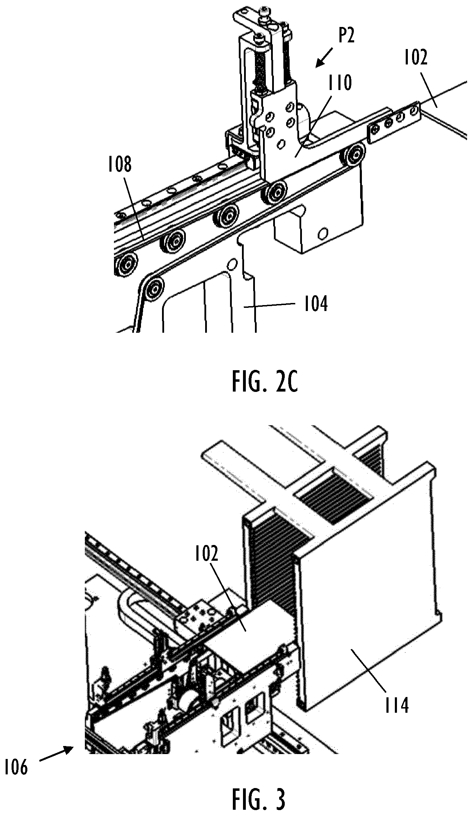

In an embodiment, the transfer member 108 is configured to move the pusher 110, when the pusher 110 is in the functional state S2, from a first position P1 to a second position P2 when the transfer member 108 is moved to a first direction D1. Figure 2B illustrates a situation wherein the pusher 110 is in the first position P1. The first position P1 is the position wherein the pusher is when the actuator 112 has set the pusher 110 to the functional state S2. In other words, substantially at the beginning of the conveyor lane 106. Figure 2C illustrates a situation wherein the pusher 110 is in the second position P2. The second position P2 is substantially at the end of the conveyor lane 106 in the conveying direction of the electronic device 102. As described earlier, the pusher 110 is in contact with the transfer member 108 when the pusher 110 is in the functional state S2. Because of the contact, the movement of the transfer member 108 moves the pusher 110 from the first position P1 to the second position P2 when the transfer member 108 is moved to the first direction D1. The first moving direction D1 of the transfer member 108 is the same direction like the transferring direction of the electronic device 102.

In an embodiment, the transfer member 108 is also configured to move the pusher 110, when the pusher 110 is in the functional state S2, from the second position P2 to the first position P1 when the transfer member 108 is moved to a second direction D2. The second transferring direction D2 of the transfer member 108 is opposite for the first transferring direction D1. The conveyor arrangement 100 may comprise a sensor or any other component which can detect when the pusher 110 is reached the second position P2 and the transfer 108 is then started to move to the direction D2. This returns the pusher 110 back to the first position P1.

In an embodiment, the pusher 110 is configured, in the movement from the first position P1 to the second position P2, to push the electronic device 102 off from the conveyor lane 106. The pusher 110 and the electronic device 102 are moved by the transfer member 108 on the conveyor lane 106 successively so that the pusher 110 moves right behind the electronic device 102. As described earlier, the contact between the transfer member 108 and the electronic device 102 may be insufficient at the end of the transfer movement before the electronic device 102 left the conveyor lane 106. Therefore, there is a risk that the transfer member 108 is not able to move the electronic device 102 totally off from the conveyor lane 106. The pusher 110, which moves on the conveyor lane 106 just behind the electronic device 102, is configured to push the electronic device 102 off from the conveyor lane 106 in the cases wherein the contact is insufficient. When the transfer member 108 is not anymore able to move the electronic device 102 properly, because of the insufficient contact, the pusher 110 is still in a firm contact with the transfer member 108 during the movement from the first position P1 to the second position P2 and hence, the pusher 110 pushes the electronic device off form the conveyor lane 106. The electronic device 102 is totally pushed off from the conveyor 106 by the pusher 110, when the pusher 110 reaches the second position P2.

Figure 3 illustrates an embodiment, wherein the pusher 110 pushes the electronic device 102 from the conveyor lane 106 into a storage structure 114. The storage structure 114 may be a part of the testing system or it may be a separate structure which is placed near the testing system. The storage structure 114 may be, for example, a magazine where the electronic device 102 which fails in the testing system is placed for the further analyses and repairing operations. In an embodiment, the failed electronic device is transferred from the testing unit into the magazine via conveyor system 100. As described earlier, at the end of the transfer movement when the electronic device 102 is partly on the conveyor lane 106 and partly out of the conveyor lane 106 the contact between the electronic device 102 and transfer member 108 is just partial. For example, the first part of the electronic device 102 may be still on the conveyor lane 106 and the second part already in the magazine. This may lead the situation wherein the transfer member 108 is not able to place the electronic device 102 into the magazine properly. In this situation the pusher 110 in the functional state S2 moves behind the electronic device 102 from the first position P1 to the second position P2 and pushes the electronic device 102 into the magazine when the pusher 110 reach the second position P2.

Figure 2C illustrates an embodiment, wherein the pusher 110 is configured, at least partly, to extend over the end of the conveyor lane 106 in the second position P2. The extending structure enables to place the electronic device 102 properly, for example, into the magazine or any other place. In the second position P2, one part of the pusher 110 is still in contact with transfer member 108 but other part of the pusher 110 extends over the end of the conveyor lane 106. The pusher 110 extends over the end of the conveyor lane 106 in the direction in which the electronic device 102 moves off from the conveyor lane 106, for example, into the magazine. In an embodiment, the extension of the pusher 110 may be adjustable to ensure the proper function of the pusher 110.

Figure 2C illustrates an embodiment, wherein the pusher 110 is configured, at least partly, to extend under the transfer surface of the transfer member 108 on the conveyor lane 106. The transfer surface of the transfer member 108 is the surface which is in contact with the pusher 110 and electronic device 102 during the movement. In some cases, the place where the electronic device 102 is going to be placed, for example, a slot of the magazine, may be below the transfer surface of the transfer member 108. Hence, the electronic device 102 may be on the lower level than the transfer surface of the transfer member 108 when the electronic device 102 is not anymore on the conveyor lane 106 but still is not yet properly placed into the magazine. Therefore, the pusher 110 which extend under the transfer surface of the transfer member 108 is able to push the electronic device 102 properly, for example, into the magazine. In an embodiment, the extension of the pusher 110 under the transfer surface of the transfer member 108 may be adjustable to ensure the proper function of the pusher 110.

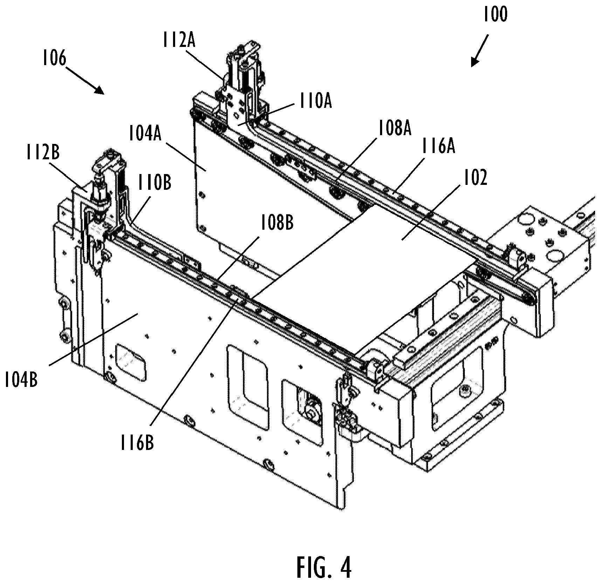

The conveyor arrangement may also comprise a guiding member 116 configured to guide the pusher 110 when moved by the transfer member 108 between the first position P1 and the second position P2. The guiding member 116 is illustrated, for example, in the Figure 1 and Figure 4. The purpose of the guiding member 116 is to ensure the right and straight movement of the pusher 110 between first position P1 and the second position P2. The guiding member 116 prevents a lateral movement of the pusher 110 and hence, ensures that the pusher 110, when moved by the transfer member 108, stays substantially on the top of the transfer member 108 in the lateral direction. This enables the proper contact between the pusher 110 and transfer member 108, and also between the pusher 110 and electronic device 102. In an embodiment, the guiding member 116 may be, for example, a guide rail which is connected, for example, to the side rail 104 or the frame of the conveyor arrangement 100. The pusher 110 may comprise a counter feature for the guide rail which enables the pusher 110 to slide along the guide rail when moved between the first P1 and the second position P2.

In an embodiment, the actuator 112 is further configured to set the pusher 110 from the functional state S2 to the non-functional state S1. For example, when the pusher 110 is set to the functional state S2 by the actuator 112 and moved by the transfer member 108 from the first position P1 to the second position P2 and back to the first position P1, the actuator 112 is further configured to set the pusher 110 back to the non-functional state S1 when the pusher 110 is not needed for pushing the electronic device 102.

In an embodiment, the conveyor arrangement 100 may further comprise a blocking member configured to block the movement of the pusher 110 in the conveying direction of the electronic device 102 when the pusher 110 is in the non-functional state S1. The blocking member may be, for example, two-piece component wherein a first part of the blocking member is, for example, in the side rail 104A, 104B or in the actuator 112 and a second part of the blocking member is in the pusher 110. For example, the first part may be a pin which is integrated into the actuator 112 and the second part may be a slot in the pusher 110 where the pin can be inserted. Hence, when the pusher 110 is in the non-functional state S1, the pin is inside the slot and prevents the movement of the pusher 110 in the transferring direction D1, D2. When the pusher 110 is set to the functional state S2, the pin comes out from the slot and releases the pusher 110 to move in the transferring direction D1, D2. In an embodiment, the blocking member may also be integrated to the actuator 112 so that the actuator 112 blocks the movement of the pusher 110 in the conveying direction of the electronic device 102 when the pusher 110 is in the non-functional state S1.

In an embodiment, the transfer member 108 comprises a belt. The belt may be, for example, a round/endless belt which rotates around belt rollers. Dimensions of the belt like, for example, a width and a length are adjusted according to the needs of the conveyor arrangement 100. The belt is used to transfer the electronic device 102 in the conveyor lane 106 and also for moving the pusher 110 between the first position P1 and the second position P2. Hence, the pusher 110 in the functional state S2 is in contact with the belt and the movement of the belt also moves the pusher 110 in the transferring direction D1, D2 between the first and second positions P1, P2.

Figure 4 illustrates an embodiment, wherein the conveyor arrangement comprises a first side trail 104A and a second side trail 104B, a first transfer member 108A and a second transfer member 108B, a first pusher 110A and a second pusher 110B and a first actuator 112A and a second actuator 112B. The first side rail 104A comprises the first transfer member 108A, the first pusher 110A and the first actuator 112A. The second side rail 104A comprises the second transfer member 108B, the second pusher 110B and the second actuator 112B. Function of the first and the second side rails 104A, 104B is substantially equal with the transfer member 108A, 108B, pusher 110A, 110B and the actuator 112A, 112B. The function of the same parts in the different side rails 104A, 104B are synchronized which means that, for example, the both transfer members 108A, 108B are moving substantially at the same time, in the same phase and to the same direction. Hence, the first and the second pusher 110A, 110B move also substantially at the same time, in the same phase and to the same direction when they are in the functional state S2 and in contact with the transfer member 108A, 108B. Also a function of the first and the second actuator 112A, 112B is synchronized same way, in other words, the both actuators 112A, 112B set the pusher 110A, 110B to the non-functional state S1 and/or functional state S2 substantially at the same time and in the same phase.

The both side rails 104A, 104B may comprise the similar transfer members 108A, 108B. The first and the second transfer member 108A, 108B may be, for example, a substantially narrow belt. The first transfer member 108A is mounted to the first side rail 104A and the second transfer member 108B is mounted to the second side rail 104B. Hence, the transfer members 108A, 108B are on the opposite sides of the conveyor lane 106 and substantially between the first and the second side rails 104A, 104B. The transfer members are also in contact with the electronic device 102 from opposite sides of the electronic device 102. These opposite sides are near the side edge of the electronic device 102 which are in parallel with the side rails 104A, 104B.

For example, the first side rail 104A comprises the first transfer member 108A which is used to transfer the electronic device 102 and also to move the first pusher 110A between the first position P1 and the second position P2. The first actuator 112A is used to set the first pusher 110A to the functional state S2 and/or non-functional state S1. The second side rail 104B with the second transfer member 108B, the second pusher 110B and the second actuator 112B works equally with the first side rail 104A. Hence, the two identical pushers 110A, 110B, which are mounted to the separate side rails 104A, 104B, push the electronic device 102 from two different points wherein the first point is near the first side rail 104A and a second point is near the second side rail 104B. The two pushing points which are far from each other and near the side edges of the electronic device 102 enables smooth moving of the electronic device 102 when pushed by the pushers 110A, 110B.

In an embodiment, with reference to Figure 4, the pusher 110A, 110B comprises a first pusher 110A (can be referred to also as a first pusher element 110A) and second pusher 110B (can be referred to also as a second pusher element 110B) operatively coupled with each other. The first pusher 110A may be arranged to push the device 102 at an area of the first rail 104A, and the second pusher 110B may be arranged to push the device 102 at an area of the second rail 104B. So, basically this may enable the pusher 110A, 110B to push the device 102 from at least two different contact points (e.g. corner areas of the device 102) and thus enable the device 102 to be pushed off from the conveyor lane 106 in an even more evenly manner. Said contact points may be situated at a distance from each other as shown in Figure 4, for example.

In an embodiment, with reference to Figure 4, the pusher 110A, 110B is configured to move with the side rail 104A, 104B when the width of the conveyor lane 106 is adjusted by moving the side rails 104A, 104B. The width of the conveyor lane 106 is adjusted according to the electronic device 102 going to be transferred on it. Both or just one of the side rails 104A, 104B may be movable for adjusting the width of the conveyor lane 106. When the pusher 110A, 110B moves with the side rail 104A, 104B, there is no need to adjust the pusher 110A, 110B into the right position separately if the width of the conveyor lane 106 is adjusted.

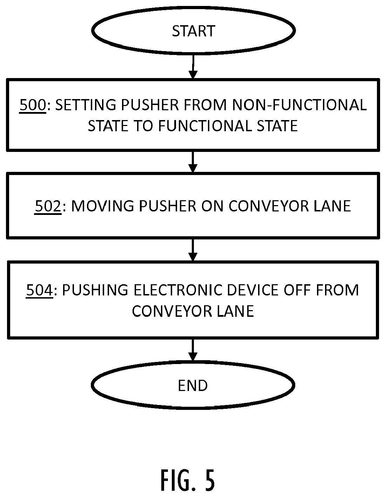

Figure 5 illustrates a flow diagram according to an embodiment. Referring to Figure 5, in step 500 the pusher 110A, 110B is set from the non-functional state S1 to functional state S2 by an actuator 112A, 112B, wherein in the functional state S2 the pusher 110A, 110B and a transfer member 108A, 108B are in contact with each other such that a movement of the transfer member 108A, 108B moves the pusher 110A, 110B. In step 502 the pusher 110A, 110B is moved on a conveyor lane 106 by the transfer member 108A, 108B. In step 504 the electronic device 102 is pushed off from the conveyor lane 106 by the pusher 110A, 110B which is moved by the transfer member 108A, 108B on the conveyor lane 106.

Next example describes the function of the test system with the conveyor arrangement. The electronic device fails in the test carried out in the testing unit of the testing system. Hence, the failed electronic device needs to be transferred from the test unit into the magazine in which the failed electronic devices are stored for further analysis and possible repair operations. The conveyor arrangement is used to transfer the failed electronic device from the testing unit into the magazine. The failed electronic device is moved from the testing unit to the conveyor lane wherein the electronic device is on the top of the transfer member. When the failed electronic device passes the pusher, which may locate at the beginning of the conveyor lane, the actuator sets the pusher from the non-functional state to the functional state. Hence, the pusher is placed in the conveyor lane just after the failed electronic device. In the functional state, the pusher is in contact with the transfer member so that the movement of the transfer member moves the pusher. Therefore, the transfer member moves the electronic devices and the pusher successively on the conveyor lane, so that the pusher moves after the failed electronic device.

The transfer member moves the pusher, which is in the functional state, from the first position to the second position. The first position is the place where the actuator sets the pusher when the pusher is set to the functional state, in other words at the beginning of the conveyor lane. The second position is at end of the conveyor lane. At the end of the conveyor lane, the failed electronic device may be partly on the top of the transfer member and partly in the magazine. This may lead the situation wherein the contact between the transfer member and the failed electronic device is insufficient. Hence, the transfer member may not be able to insert the failed electronic device properly into the magazine, especially if the magazine has not the apparatus which may assist the movement of the electronic device from the conveyor to the magazine. Therefore, the pusher which moves just behind the failed electronic device, pushes the electronic device properly into the magazine when the pusher reaches the second position. The pusher is then moved by the transfer member from the second position back to the first position by moving the transfer member to the second direction which is opposite for the movement which was used for transferring the failed electronic device toward the magazine. When the pusher reaches the first position, the actuator set the pusher from the functional state back to the non-functional state.

The conveyor arrangement may comprise a controller comprising at least one processor and at least one memory. Their operation is based on a sequence of program commands of the computer program controlling the operation of the conveyer arrangement and/or the testing system. The computer program may be stored in the at least one memory. The computer program may be distributed using a distribution medium which may be any medium readable by the controller. The medium may be a program storage medium, a memory, a software distribution package, or a compressed software package. In some cases, the distribution may be performed using at least one of the following: a near field communication signal, a short distance signal, and a telecommunications signal.

The conveyor arrangement 100 may further comprise sensors for detecting different states or movements of the parts used in the conveyor arrangement 100 or the electronic device 102 which is transferred in the conveyor arrangement 100. The sensors may be placed in the different places in the conveyor arrangement 100. For example, the sensor may be utilized to detect the movement of the pusher 110A, 110B between the first position P1 and the second P2 or between the non-functional state S1 and functional state S2. The sensor may also detect the movement and positions of the electronic device 102. The sensors may comprise, for example, electrical sensors, magnetic sensors, pressure sensors or optical sensors.

According to an example embodiment, there is provided the test system comprising the conveyor arrangement 100. The test system may be configured to test device 102 and/or similar devices.

Many of the example embodiments described above relates to the testing system of the electronic device 102, but the usage of the conveyor arrangement 100 in the manufacturing process is not limited only to the testing system. The testing system is only one example area in which the conveyor arrangement 100 may be applied. The conveyor arrangement 100 according to the invention may be used anywhere in the electronic manufacturing processes wherein the conveyor(s) may be used for conveying the electronic devices 102.

It will be obvious to a person skilled in the art that, as technology advances, the inventive concept can be implemented in various ways. The invention and its embodiments are not limited to the example embodiments described above but may vary within the scope of the claims.

## Claims

1. A conveyor arrangement (100) for conveying an electronic device (102), the conveyor arrangement (100) comprising:
side rails (104A, 104B) configured to form a conveyor lane (106) for transferring the electronic device (102);
a transfer member (108) configured to transfer the electronic device (102) along the conveyor lane (106);
a pusher (110) configured to push the electronic device (102) off from the conveyor lane (106); and
an actuator (112) configured to set the pusher (110) from a non-functional state (S1) to a functional state (S2), wherein in the functional state (S2) the pusher (110) and the transfer member (108) are configured to be in contact with each other such that a movement of the transfer member (108) is configured to move the pusher (110) to push the electronic device (102) off from the conveyor lane (106).

2. The conveyor arrangement (100) according to claim 1, wherein the transfer member (108) is configured to move the pusher (110), when the pusher (110) is in the functional state (S2), from a first position (P1) to a second position (P2) when the transfer member (108) is moved to a first direction (D1).

3. The conveyor arrangement (100) according to claim 2, wherein the transfer member (108) is further configured to move the pusher (110), when the pusher (110) is in the functional state (S2), from the second position (P2) to the first position (P1) when the transfer member (108) is moved to a second direction (D2).

4. The conveyor arrangement (100) according to any preceding claim, wherein the pusher (110) is configured in the movement from the first position (P1) to the second position (P2) to push the electronic device (102) off from the conveyor lane (106).

5. The conveyor arrangement (100) according to any preceding claim, wherein the pusher (110) is configured in the movement from the first position (P1) to the second position (P2) to push the electronic device (102) from the conveyor lane (106) to a storage structure (114).

6. The conveyor arrangement (100) according to any preceding claim, wherein at least part of the pusher (110) extends over an end of the conveyor lane (106) when the pusher (110) is in the second position (P2).

7. The conveyor arrangement (100) according to any preceding claim, wherein a part of the pusher (110) extends below a transfer surface of the transfer member (108) when the pusher (110) is in the functional state (S2) and in contact with the transfer member (108).

8. The conveyor arrangement according to any preceding claim, wherein the conveyor arrangement comprises a guiding member (116) configured to guide the pusher in the functional state (S2) when moved by the transfer member (108) to direction which is parallel with a conveying direction of the electronic device (102) on the conveyor lane (106).

9. The conveyor arrangement according to any preceding claim, wherein the actuator (112) is further configured to set the pusher (110) from the functional state (S2) to the non-functional state (S1).

10. The conveyor arrangement (100) according to any preceding claim, wherein the conveyor arrangement (100) comprises a blocking member configured to block the movement of the pusher (110) in the conveying direction of the electronic device (102) when the pusher (110) is in the non-functional state (S1).

11. The conveyor arrangement (100) according to any preceding claim, wherein the transfer member (108) comprises a belt.

12. The conveyor arrangement (100) according to any preceding claim, wherein the conveyor arrangement (100) further comprises:
a first side rail (104A) and a second side rail (104B) configured to form the conveyor lane (106) for transferring the electronic device (102);
a first transfer member (108A) and a second transfer (108B) member configured to transfer the electronic device (102) along the conveyor lane (106);
a first pusher (110A) and a second pusher (110B) configured to push the electronic device (102) off from the conveyor lane (106); and
a first actuator (112A) configured to set the first pusher (110A) from a non-functional state (S1) to a functional state (S2) and a second actuator (112B) configured to set the the second pusher (110B) from a non-functional state (S1) to a functional state (S2), wherein in the functional state (S2) the first pusher (110A) and the first transfer member (108A) are configured to be in contact with each other and the second pusher (110B) and the second transfer member (108B) are configured to be in contact with each other such that a movement of the transfer members (108A, 108B) is configured to move the pushers (110A, 110B) to push the electronic device (102) off from the conveyor lane (106);
wherein the first transfer member 108A, the first pusher 110A and the first actuator 112A is associated with the first side rail 104A, and the second transfer member 108B, the second pusher 110B and the second actuator 112B is associated with the second side rail 104B.

13. The conveyor arrangement according to any preceding claim, wherein the pusher (110A, 110B) is configured to move with the side rail (104A, 104B) when a width of the conveyor lane (106) is adjusted by moving the side rail (104A, 104B).

14. A method for conveying an electronic device (102), the method comprising:
setting, by an actuator (112A, 112B), a pusher (110A, 110B) from a non-functional state (S1) to a functional state (S2), wherein in the functional state (S2) the pusher (110A, 110B) and a transfer member (108A, 108B) are in contact with each other such that a movement of the transfer member (108A, 108B) moves the pusher (110A, 110B);
moving, by the transfer member (108A, 108B), the pusher (110A, 110B) on a conveyor lane (106); and
pushing, by the pusher (110A, 110B), the electronic device (102) off from the conveyor lane (106).

15. A computer program product comprising instructions to cause a conveyor arrangement to execute the steps of the method of claim 14.
